# EUROPEAN PATENT SPECIFICATION

(11) **EP 4 241 051 B1**
(45) Date of publication and mention of the grant of the patent: **21.08.2024**
(21) Application number: 22777201.9
(22) Date of filing: 13.09.2022
(51) Int. Cl.: G01J 1/44, H01L 31/02

(54) **PERSISTENCE FILTERING IN SPD ARRAYS**
PERSISTENZFILTERUNG IN SPD-ARRAYS
FILTRAGE DE PERSISTANCE DANS DES RÉSEAUX SPD

(30) Priority: 21.09.2021 BE 202105744
(43) Date of publication of application: 13.09.2023
(60) Divisional application: 24188593.8
(73) Proprietor: VoxelSensors SRL, 1000 Brussels (BE)
(72) Inventor: VAN DER TEMPEL, Ward, 3140 Keerbergen (BE); PEETERS, Johannes Willem, 2000 Antwerpen (BE); MIODEZKY, André Bernard, 1180 Uccel (BE); MOURAD, Christian, 1332 Genval (BE)
(86) International application number: PCT/IB2022/058609
(87) International publication number: WO 2023/047245

(56) References cited:
- WO-A1-2019/060942
- US-A1- 2019 326 347
- US-A1- 2020 266 222
- US-A1- 2020 410 272

## Description

### TECHNICAL DOMAIN

The invention relates to an improved method, detector element and system for high-speed imaging based on single-photon detectors (SPD), whereby false positives are filtered out of the results.

### PRIOR ART

In the prior art, in scanning active imaging, a light beam, typically a laser, is moved over an area to be captured, and the location where the beam impinges is recorded at each point in time via multiple image sensors. By processing the differences in location from the different points of view (sensors), the effective distance to the illuminated target can be determined, via triangulation. Such a measurement captures a voxel. The speed at which this process can be carried out, the voxel rate, is limited on the one hand by the speed at which scanning with the light beam takes place, but on the other hand is also (the most strongly) limited by the processing time required by the sensors to detect the reflected light beams, especially in relation to background radiation (ambient light) and general thermal noise. By specifically tackling this second issue, imaging can be significantly accelerated.

The high-speed imaging systems in prior art thus have to contend with a number of requirements and problems. A first one is the accuracy with which incident photons are detected. Increasingly higher demands are made in terms of spatial resolution, resulting in the sensor arrays having increasingly more separate detectors (pixels). This means increased computing power is needed to read all said detectors and to process the output signals into an image. Because the separate pixels always (have to) become smaller, the photosensitivity must also increase, as they have a limited spatial window to capture photons. In addition, it must also be possible to achieve a certain processing speed. In order to achieve a voxel rate of tens or even hundreds of millions of voxels per second, each voxel must be captured in a time span of at most 10 ns. As a result, the sensor must also be suitable for operating with limited photon budgets (i.e. detected photons incident on the sensor that are sufficient for a detection), such as, for example, 10 photons. Given the limited time span for processing, only a limited number of photons can be captured.

For this reason very sensitive detectors, such as SPDs or SPADs (single photon - avalanche - detectors), are often considered.

However, said detectors have the inherent disadvantage that the increased photosensitivity also causes unwanted excitations, both due to ambient light and due to thermal noise. In itself such excitations on detector level are difficult to distinguish from 'genuine' detections resulting from the incidence of reflected light that was deliberately emitted by the system to scan a scene.

Currently, no sensor architecture systems or methods exist that are capable of reaching the desired detection speeds under the proposed characteristics such as photon budget and at the same time while assuring that a minimum number of false positives is detected.

D1 discloses a time-of-flight (TOF) sensor includes a light source, a plurality of avalanche photodiodes, and a plurality of pulse generators. Control circuitry is coupled to the light source, the plurality of avalanche photodiodes, and the plurality of pulse generators, and the control circuitry includes logic that when executed by the control circuitry causes the time-of-flight sensor to perform operations. The operations include emitting the light from the light source, and receiving the light reflected from an object with the plurality of avalanche photodiodes. A plurality of pulses is output from the individual pulse generators corresponding to the individual avalanche photodiodes that received the light, and a timing signal is output when the plurality of pulses overlap temporally. A time is calculated when a first avalanche photodiode in the plurality of avalanche photodiodes received the light.

D4 discloses a vision sensor includes a pixel array comprising pixels arranged in a matrix, an event detection circuit, an event rate controller, and an interface circuit. Each pixel is configured to generate an electrical signal in response to detecting a change in incident light intensity. The event detection circuit detects whether a change in incident light intensity has occurred at any pixels, based on processing electrical signals received from one or more pixels, and generates one or more event signals corresponding to one or more pixels at which a change in intensity of incident light is determined to have occurred. The event rate controller selects a selection of one or more event signals corresponding to a region of interest on the pixel array as one or more output event signals. The interface circuit communicates with an external processor to transmit the one or more output event signals to the external processor.

The purpose of the present invention is to find a solution for at least a number of the aforementioned problems.

### SUMMARY OF THE INVENTION

The invention relates to an improved high-speed imaging method according to claim 1.

Where existing SPD, and in particular SPAD, arrays have to contend with a very high number of false positives, due to, among others thermal noise and ambient light, the purpose of this invention is filtering out said random false detection signals. In existing systems, each photon impinging on an SPD or SPAD generates a detection signal, as said components are specifically designed to be able to also record their incidence in case of low photon densities, which benefits the speed and resolution. The smaller SPD/SPAD surface allows more SPD/SPAD per surface and therefore a higher resolution, but therefore also lowers the risk of photon incidence, such that the sensitivity of the components must lie higher, and thus trigger them faster. Consequently, false positives are inevitable in most systems, and the purpose of the present invention is to recognise said false positives and filter them out of the results, and only confirm the 'real' photon incidences (coming from an active illumination of an object or scene by a light source of the system).

Preferred embodiments are described in the subsequent claims.

In a second aspect the invention relates to a detector element and a sensor system for high-speed imaging, preferably suitable for executing the method according to the first aspect, as specified in claims 12, and 13 and 14.

### DESCRIPTION OF THE FIGURES

**Figures 1A-C** **and** **2A-C** show the time lapse of the illumination patterns (Figure 1A and 2A), the detections of photon incidences with an active illumination signal (Figure 1B and 2B) and the detections of photon incidences without an active illumination signal (Figure 1C and 2C).
**Figure 3** shows a circuit to impose a first persistence condition according to an embodiment of the invention.
**Figure 4** shows a circuit to impose a second persistence condition according to an embodiment of the invention.
**Figure 5** shows a circuit to impose a third persistence condition according to an embodiment of the invention.
**Figure 6** shows a circuit to impose a third persistence condition according to an embodiment of the invention, coupled with a calibration circuit.
**Figure 7** shows a circuit to impose a third persistence condition according to an embodiment of the invention, coupled with a calibration circuit and local coincidence circuits.
**Figure 8A** shows a first calibration circuit according to an embodiment of the invention.
**Figure 8B** shows a circuit to impose a persistence condition according to an embodiment of the invention, coupled with the calibration circuit according to Figure 8A.
**Figure 9A** shows a second calibration circuit according to an embodiment of the invention.
**Figure 9B** shows a circuit to impose a persistence condition according to an embodiment of the invention, coupled with the calibration circuit according to Figure 9A and the calibration circuit of Figure 8A.

### DETAILED DESCRIPTION

Unless otherwise defined, all terms used in the description of the invention, including technical and scientific terms, have the meaning as generally understood by the person skilled in the technical field of the invention. For a better evaluation of the description of the invention, the following terms are explicitly explained.

"A", "an" and "the" refer to both the singular and the plural in this document unless the context clearly suggests otherwise. For example, "a segment" means one or more than a segment.

When "approximately" or "around" are used in this document for a measurable quantity, a parameter, a duration or moment, and the like, variations of +/-20% or less, preferably +/-10% or less, more preferably +/-5% or less, still more preferably +/-1% or less, and even more preferably +/-0.1% or less than, and of, the quoted value are meant, to the extent that such variations are applicable in the invention described. However, it should be understood that the value of the quantity for which the term "approximately" or "around" is used is itself specifically disclosed.

The terms "comprise", "comprising", "consist of", "consisting of", "provided with", "contain", "containing", "include", "including", "hold", "holding" are synonyms and are inclusive or open terms indicating the presence of what follows, without excluding or precluding the presence of other components, characteristics, elements, members, steps, known from or described in prior art.

The term "pixel" refers to a light-sensitive unit or detector here, preferably in the form of an SPD or SPAD. Typically, said pixels are provided in an array like a matrix.

The term "macropixel" hereby refers to a virtual pixel comprising several pixels or detectors, which typically form a contiguous cluster. Said macropixel may be associated to a certain set of spatiotemporal conditions, and vary depending on the circumstances in terms of size, form and other parameters. Macropixels can partially overlap with each other, and have pixels or detectors in common. Preferably, a macropixel has a square or rectangular form, but can also be approximately circular or oval, triangular, cross- or star-shaped, or have other forms. A macropixel comprises at least 2 detectors (e.g. in 2 × 1 or 1 × 2 matrix form), and more preferably at least 4 detectors (e.g. 2 × 2).

Quoting numerical intervals by the end points comprises all integers, fractions, and/or real numbers between the end points, including said end points.

In a first aspect the invention relates to a high-speed imaging method based on an array comprising a plurality of single photon detectors (SPD), preferably single photon avalanche detectors (SPAD), comprising the following steps:
a. capturing photons on the SPDs, whereby the SPDs generate a detection signal C_ov and provide it to an evaluation circuit, whereby the detection signal describes a positive observation status when an observation takes place by the SPD of an electromagnetic radiation to be detected, and describes a negative observation status in the absence of the observation by the SPD;
b. evaluing the detection signals of the SPD by the evaluation circuit per SPD, whereby a persistence condition must be met by the detection signals per SPD to generate a confirmation signal for the SPD of the electromagnetic radiation to be detected;

The persistence condition for at least one, and preferably every, SPD requires a positive observation status for the same SPD in at least M, preferably consecutive, observation windows, preferably with period T, over the past N observation windows, with M greater than 1 and at most equal to N.

By looking at the observation status in the past N observation windows, it is possible to verify whether a positive observation status is persistent, and thus confirmed by earlier measurements. In this way, false positives caused by thermal noise and the like, are filtered out of the results. Only if a certain number or certain percentage of the past N observation windows also shows a positive observation status, is the detection confirmed based on a confirmation signal. Said evaluation can be done locally, per pixel or SPD/SPAD, or centralised whereby this is done for all (or a subsection of) SPDs/SPADs, in an evaluation component or circuit.

It must be understood that the persistence condition of M (consecutive or not) of the N observation windows can also be applied in alternative ways, among others with a percentage M/N of the past N observation windows (again, with the condition or not that said M are consecutive, whereby M is then typically equal to N).

It goes without saying that more specific persistence conditions can be applied as desired (e.g. at least M of the past N with positive observation status and therein at least P consecutive positive observation statuses; maximum Q consecutive non-positive observation statuses; at least 2, 3, ... clusters of P consecutive positive observation statuses; etc.). Combinations and variations of this obviously also belong to the invention.

The aforementioned method allows 'active' radiation to be consistently detected, because typically said radiation impinges extensively in a certain zone over a certain time period, and thus meets the persistence condition, unlike thermal noise and other unwanted detections.

In a first preferred embodiment, the method comprises illuminating a scene with a scanning light source (of which an image must be formed: object, environment, etc.) using one or several light sources (laser, LED, etc.) based on a predefined illumination pattern. Said illumination pattern comprises temporally separated light pulses (with constant length and/or interval or not).

The observation windows based on which the persistence condition is imposed are temporally associated to one of the light pulses, and the detection signal shows the occurrence or non-occurrence of an observation by the SPD (positive observation status or not).

Temporally associating the observation windows to the light pulses is timing the observation window such (in terms of start and/or end time) that they largely overlap, such that the observed radiation in the observation windows can be linked with very high probability to the light pulses (and thus not to thermal noise or other noise signals).

The applicant notes that a balance needs to be found, i.e. number of light pulses in the illumination pattern (and the pulse length and the time between the pulses), and the desired speed at which the system can work. More pulses/longer pulses/longer intervals means that evaluating the signals on an SPD from every discrete position takes longer. For this reason N is typically set between 2 and 10, preferably between 2 and 7, more preferably between 2 and 5, such as 2, 3, 4 or 5.

In a preferred embodiment, the observation windows are set to largely overlap with the light pulses to which they are associated (i.e. largely covering the time period of the light pulses, but not necessarily limited hereto), with start times substantially coinciding (and whereby the start time of the observation windows is at the earliest simultaneous with those of the light pulses). Substantially coinciding implies that the start time of the observation window lies between 0.0 ns and 1.0 ns after the start time of the light pulse, preferably at most 0.5 ns, and even more preferably at most 0.1 ns or even 0.05 ns. Consequently it is ensured that (practically) all radiation that impinges during the observation window comes from events from the time period of the light pulse. The start time allows some play which takes into account time-of-flight.

In a preferred embodiment, the detectors are provided with a quenching circuit. More preferably this is a passive quenching circuit. Alternatively this is an active quenching circuit.

In a preferred embodiment, the observation windows are set with an end time between 0.0 ns and 25.0 ns after the end time of the associated light pulse, preferably between 0.05 ns and 15.0 ns, more preferably between 0.1 ns and 10.0 ns after the end time of the associated light pulse. As explained above, such timing ensures that the radiation coming from events during the time period of the light pulse, is captured in the observation window, taking into account the time-of-flight.

By simultaneously applying the aforementioned restrictions of start and end time, the number of photons not caused by the light pulse and captured during the observation window, is reduced as much as possible.

In a second alternative preferred embodiment, the method comprises a step of illuminating a scene with one or more scanning light sources, whereby the light sources illuminate the scene substantially continuously. This means that the light source illuminates continuously and with a substantially constant intensity. In this case the observation windows can be chosen more arbitrarily, and if relevant even contiguously.

The light sources are used to emit an active and controlled light signal, and consequently to illuminate a scene/object of which an image will be formed. The SPDs capture reflected photons and register said incidence based on a detection signal to a further component, to thus form an image of the illuminated scene/object.

The method thus comprises illuminating a scene or object with the light source(s), whereby the light source illuminates in discrete or quasi-discrete steps, and for each discrete or quasi-discrete position that is illuminated, briefly continues illuminating before going to a next discrete position. In fact, the term "discrete position" herein refers to a discrete orientation of the light source, which comes down to a certain discrete position that is illuminated. The 'route' of discrete positions that is followed during illuminating can be randomised, but typically follows a scanning pattern, row per row or column per column. However, it needs to be noted that the invention is not limited in this aspect in any way whatsoever. "Quasi-discrete" hereby refers to situations in which the light source continues to vary its orientation, but at a speed such that the covered distance of illuminated zones in case of (2 or more) consecutive observation windows is very limited, and can be considered as the same discrete zone. In what follows "discrete" therefore needs to be interpreted as comprising quasi-discrete.

Preferably, M and/or N are adjustable, and even more preferably even adjustable per SPD. In certain embodiments they can be set dynamically, such that the system automatically adapts them on detection of many or few noise detections (detection signals whereby the persistence condition is not met) for an SPD. Thus the persistence condition can be relaxed for SPDs where little noise is observed statistically, and tightened where more noise is observed statistically, to thus be able to operate more quickly and accurately.

Making M and/or N separately adjustable can therefore be used to make certain SPDs more sensitive or less sensitive, such as for example upon detection of many detection windows with detection signals without active light, which may point to a 'leaky pixel'. They can even be completely switched off if necessary.

In a preferred embodiment, M and/or N are automatically adapted based on a calibration routine.

In a preferred embodiment, the persistence condition is combined with meeting a coincidence condition. This builds on the assumption that in the event of observations by the SPD, the incidence of a photon on a certain SPD is not single, but involves the incidence of a bundle of photons that are spatially clustered. Based on this the coincidence condition is imposed which in a certain time period around a positive observation status or a confirmation signal of an SPD verifies the observation status or confirmation signals of neighbouring SPDs.

The coincidence condition can be imposed before or following the persistence condition, and depending on the circuit is more efficient in one way or another.

In this way, for a first SPD that meets the persistence condition, the coincidence condition can be imposed subsequently, and only after it is met a confirmation signal is generated. Preferably, the coincidence condition implies that at least one adjacent SPD (adjacent to the first SPD) also meets the persistence condition. Obviously this can be narrowed to at least 2, 3, 4, etc. of the adjacent SPDs that have to meet the persistence condition.

The term "adjacent SPD" primarily refers to the directly adjacent SPDs. The SPDs are typically provided in a rectangular array of rows and columns, which means that the adjacent SPDs are situated in one and the same row and neighbouring column or one and the same column and neighbouring row. However, the term can be simply expanded to comprise for example diagonally adjacent SPDs (neighbouring row and neighbouring column), or even wider still, such that 'opposite neighbours' are also included herein. The coincidence condition can be imposed in a number of ways and with variable conditions. Thus, the number of adjacent SPDs that meet the persistence condition can be adapted (1, 2, 3, 4, 5, 6, 7, 8, 9 or more), but the definition of "adjacent" can also be adapted. Thus, in a preferred embodiment adjacent can be interpreted as "directly adjacent", but "diagonally adjacent" SPDs can also be accepted (directly adjacent to a first directly adjacent SPD in another dimension than the first SPD is directly adjacent), and this can also be defined as lying within a predefined interval of the original SPD (and thus also allow opposite neighbours). Again this can be varied depending on the circumstances, and the system can even adapt this dynamically (for example via a calibration routine).

By first imposing the persistence condition, a first filtering is applied, after which the coincidence condition only has to be applied on the remaining detections that are confirmed according to the persistence condition. This sequence ensures that the computationally most challenging condition (coincidence condition, as it needs to take into account the signals of a number of adjacent SPDs) has to be applied to a lower number of signals.

The first method means that adjacent SPDs to a first SPD with position (i,j) are simplly defined as having coordinates(i,j±1) or (i±1,j). To add diagonally adjacent SPDs, SPDs with coordinates (i±1,j±1) are also accepted.

If desired, the scope of "adjacent SPDs" can thus also be expanded with SPDs with coordinates (i±2,j±1), (i±1,j±2), (i±2,j), (i,j±2), again possibly supplemented by (i±2,j±2).

It goes without saying that further expansions belong to the possiblities, and are implicitly considered part of the invention.

Thus, the coincidence condition based on the definition of adjacent SPDs can also be adapted, whereby every SPD is given a weight based on the 'distance' in the array relative to the first SPD. Only on reaching a certain weight in SPDs for which the persistence condition is met, is the coincidence condition considered to be met for the first SPD.

Reversely, first the coincidence condition can be imposed for an SPD (as described above, but per observation window based on a positive observation status in said observation window instead of meeting the persistence condition), and only for the SPDs where the coincidence condition is met, is meeting the persistence condition subsequently checked.

In a second aspect the invention relates to a detector element comprising: a single photon detector (SPD), preferably a single photon avalanche detector (SPAD), configured to generate a signal C_ov which describes a status of the occurrence or non-occurrence of an observation by the SPD of the electromagnetic radiation (photons) to be detected for consecutive observation windows; a memory element that remembers the status of the SPD at the end of at least N previous observation windows, N being a natural number equal to or greater than 1; a logical circuit configured to generate a confirmation signal if the signal of the SPD at the end of a current observation window and of at least M of the N previous observation windows indicates an observation by the SPD , M being a natural number equal to or greater than 1 and at most equal to N.

In such case it is possible to have the detector elements impose the persistence condition separately to their own observations, and to only generate and deliver a confirmation signal to a central processing unit if this is met. Examples of possible embodiments of this are discussed further in the text and figures.

Alternatively, the persistence condition is executed in a centralised way to keep the detector elements simpler.

In a preferred embodiment the consecutive light pulses are separated at least 0.5 ns, preferably at least 1.0 ns, even more preferably at least 2.5 ns, and most preferably at least 5.0 ns.

In a preferred embodiment the consecutive light pulses are separated at most 1000 ns, preferably at most 500 ns, even more preferably at most 100 ns, and most preferably at most 50 ns.

The highest preference combines the aforementioned minimum and maximum values to a corresponding range.

In a preferred embodiment the length of the light pulses of the predefined illumination pattern and the length of the associated observation windows have a ratio located between 1.0 and 2.0, preferably between 1.0 and 1.5 and most preferably between 1.0 and 1.25. In this way it is guaranteed that as many as possible signals caused by the light pulses are captured in the observation window, without making this needlessly long (such that the method would be slower).

In a preferred embodiment the observation statuses of the past N windows are saved by memory elements on the SPAD or on a central processing unit (which imposes the persistence condition for several, or even all SPADs of the array), whereby 'obsolete' observation statuses (more than N windows ago) are overwritten by newer ones. Such memory elements may include flipflops, DRAM (dynamic RAM), SRAM (static RAM), analogue memory elements or other components.

By linking said observation statuses to a suitable logical circuit (e.g. modified AND-port), it can be ensured in a simple way that the desired processing of the signals is achieved and a confirmation only follows on meeting the persistence condition.

Prior to the logical circuit (and memory elements), preferably a buffer element is provided to isolate the operation of SPAD and the processing of the signals from each other.

In certain embodiments, for example if N only equals 2, a so-called delay circuit can be provided which includes the signal from a previous observation window and feeds it to a logical circuit, such as a simple AND-port, together with the signal of a current observation window. As typically the observation windows come at fixed time intervals, such circuit can be executed in a simple way, without the need for many additional components. In addition, the persistence condition can be applied locally on the SPAD itself, such that only the (non-) confirmation signal to a further processing unit is provided.

A number of possible circuits are shown for this in the figures, possibly in combination with further adjustments and improvements.

In a third aspect the invention relates to a sensor system for high-speed imaging, comprising a matrix/array of detector elements according to the second aspect of the invention; and a circuit for reading the detector elements in the matrix/array. By providing the detector elements with their own evaluation circuit, a part of the computational load can be decentralised in a simple way, and only confirmation signals are communicated to the central reading circuit.

Not according to the claimed invention, a sensor system for high-speed imaging in its third aspect, comprising:
a. A matrix/array of detector elements, whereby the detector elements comprise a single photon detector (SPD), preferably a single photon avalanche detector (SPAD), the SPD being configured to generate a signal C_ov which describes a status of the occurrence or non-occurrence of an observation by the SPD of the electromagnetic radiation (photons) to be detected for consecutive observation windows;
b. a logical circuit for reading the signals C_ov of the detector elements in the matrix/array, the aforementioned logical circuit being provided with one or more memory elements;

The one or more memory elements are hereby configured to remember the status of the SPD at the end of at least N previous observation windows per SPD, N being a natural number equal to or greater than 1. The logical circuit is configured to generate a confirmation signal for an SPD if the signal of the SPD at the end of a current observation window and of at least M of the N previous observation windows of the SPD indicate an observation by the SPD , with M being a natural number equal to or greater than 1 and at most equal to N. In this way the detector elements are kept simple (and thus more compact, cheaper, more robust) and the computational load is borne centrally.

In a preferred embodiment, the sensor system is configured for executing a method according to the first aspect of the invention.

In a further aspect, the invention relates to a method for calibrating imaging systems comprising an array which comprises a plurality of single photon detectors (SPD), preferably single photon avalanche detectors (SPAD). The method relates to the monitoring of the observation status/detection signals over a calibration time period by an evaluation circuit (either with one evaluation circuit or per SPD, per group of SPDs or for the whole system), in at least two, preferably at least three calibration windows in the calibration time period. Preferably, the calibration windows are temporally separated from each other, and run during periods in which the array of SPDs is not actively illuminated (i.e. deliberately with light sources controlled by the system).

The number of calibration windows can be set higher, and thus allow a more thorough and reliable classification, for example, 5, 6, 7, 8, 10 or more calibration windows. The calibration windows can be contiguous or separated from each other.

Based on the number of calibration windows in which an observation by the SPD is detected, the SPDs are then classified separately in a number of categories. The number of classifications or the way of classifying can be set depending on the situation. Thus two classes can be chosen (reliable - unreliable), or more than two classes.

The classification indicates to what extent an SPD is sensitive to noise and the like, and can be used in the processing of further detection signals for imaging. More specifically, the calibration method can be applied in light of the invention according to the previous aspects (prior to this), and the further processing of signals of SPDs can be adapted based on the classification thereof, and more specifically the persistence condition can be adapted for the SPDs based on the aforementioned classifications, such as a tightening or relaxing of said conditions (M higher or lower, or even the complete deactivation of the persistence condition, or M = 1), and/or the deactivation of certain SPDs where too great an error is detected (e.g. screamers where a positive observation status is indicated by the detection signals too frequently statistically).

In a first embodiment, the SPDs can be split into two classifications, high priority (HP) and low priority (LP), indicating the reliability. HP SPDs are considered to be more reliable, and can operate under more relaxed persistence conditions and/or coincidence conditions than LP SPDs. In a non-restrictive example, LP SPDs have a positive observation status in at least T % of the calibration windows, whereby T is preferably at least 50%, even more preferably at least 66% or even 75%.

In addition, further classifications can be provided (medium priority or MP; high medium priority, HMP; low medium priority LMP; etc.) depending on your choice, all associated to a separate way of processing during the imaging (stricter or more relaxed persistence condition) associated to certain ranges of percentages of positive observation statuses detected in the calibration windows for the SPD.

The adaptation of the conditions can be strongly varied, such as simply M incrementing by one for each decrease in calibration level (decreasing from HP to LP), but it can just as well be a different adaptation for every category change.

The adapted persistence and/or coincidence conditions belonging to a certain classification are preset and the evaluation circuits are configured to suitably execute them.

In a preferred embodiment, the observation statuses of the past N calibration windows are saved by memory elements on the SPAD or on a central processing unit (which imposes the persistence condition for several, or even all SPADs of the array), whereby 'obsolete' observation statuses (more than N windows ago) are overwritten by newer ones. Such memory elements may include flipflops, DRAM (dynamic RAM), SRAM (static RAM), analogue memory elements or other components.

By linking said observation statuses to a suitable logical circuit (e.g. modified AND-port), it can be ensured in a simple way that the SPDs are classified as desired.

In certain embodiments, for example if N only equals 2, a so-called delay circuit can be provided which includes the signal from a previous calibration window and feeds it to a logical circuit, such as a simple AND-port, together with the signal of a current calibration window. As typically the observation windows come at fixed time intervals, such circuit can be executed in a simple way, without the need for many additional components. In addition the calibration can be applied locally on the SPAD itself.

A number of possible circuits are shown for this in the figures, possibly in combination with further adjustments and improvements.

Keeping status information in every pixel of a previous observation window is possible with a big variety of implementations, for example, but not limited to, through the use of flipflops, but also memory elements such as SRAM and/or DRAM elements, or simple possibly parasitic capacitors that can save a load.

In what follows, the invention is described by means of non-limitative examples which illustrate the invention, and which are not intended or must not be interpreted to limit the scope of the invention.

### EXAMPLES

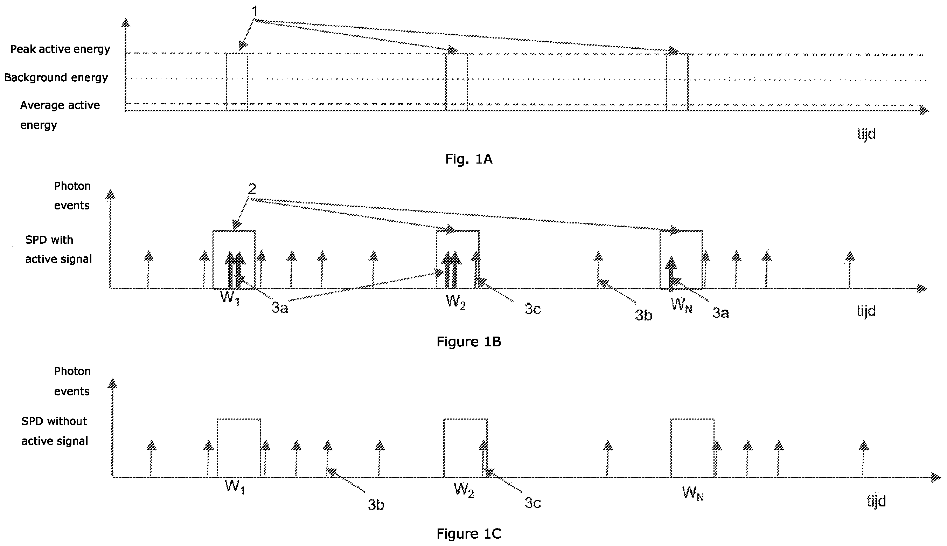

Figures 1A-C show the emitted and received signals for a possible embodiment of the invention.

Figure 1A shows a time lapse of the illumination by the light sources on a certain SPD, whereby a pulsing illumination pattern is maintained with square waves (1) with a fixed length and period, in which during every period the scene is actively illuminated by the light source for a time and is not actively illuminated by the light source for a time.

Figure 1B shows detected events for an SPD, whereby every event (3a, 3b, 3c) shows an incidence of a photon on the SPD. Part of said events are the result of ambient light, random noise or error signals (3b, 3c), and a part of the events come from photons emitted by the light source (3a). In principle, statistically the first group has a random distribution, the second group will be in the time periods in which the light source emits light.

Observation windows (2; W₁, W₂, W_{N}) are also visible in Figure 1B, in this case again with a fixed length and fixed period, for which the observation status of the SPD is registered (the possible detection of a photon incidence during the observation window). By illuminating with an active signal, chances are great that one or more events are detected in the observation window (which falls in the illumination square wave). Figure 1C finally shows detected events (3b, 3c), without the events that are the result of illumination by the light sources, again with the observation windows indicated.

It is clear from Figure 1C that in some observation windows, events (3c) still take place due to the random distribution of detected events, and could then be incorrectly considered as a detection of an incident photon on the SPD. However, by imposing the persistence condition that for example in two consecutive observation windows (or even three, or two out of three, etc. depending on the imposed persistence condition) a positive observation status must be observed (i.e. a detected event in the observation window), it is ensured that said random events are no longer evaluated as a 'real' detection in the imaging. Figure 1C indeed only shows one observation window with a positive observation status.

However, the 'real events' (3a), as a result of illuminating with an active signal, are indeed confirmed, considering that in Figure 1B in two consecutive (and even in all) observation windows a positive observation status is observed, and the persistence condition is met.

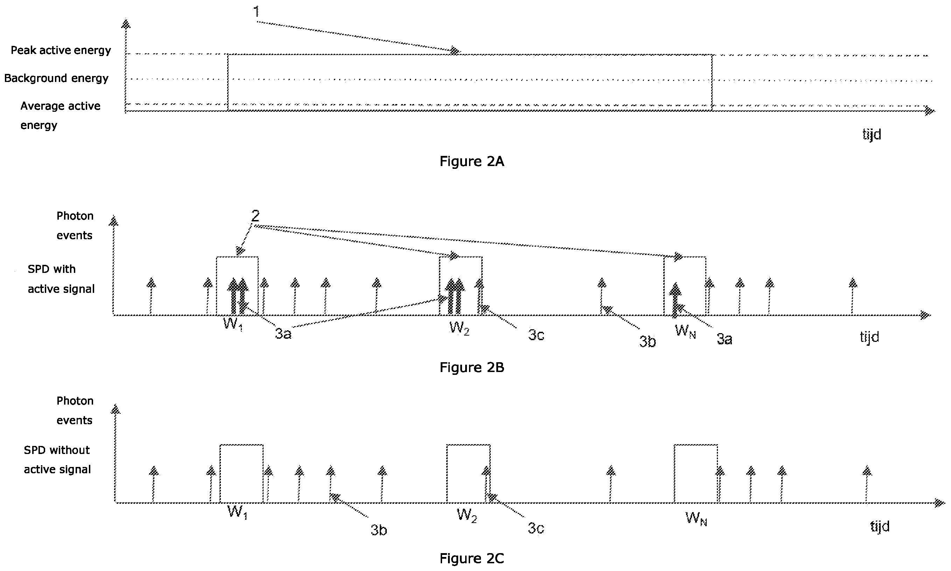

Figures 2A-C show the same graphs, with the difference that, as is visible in Figure 2A, the light is not pulsed, but continuous. Figure 2B hereby only shows the events caused by the illumination in the observation windows.

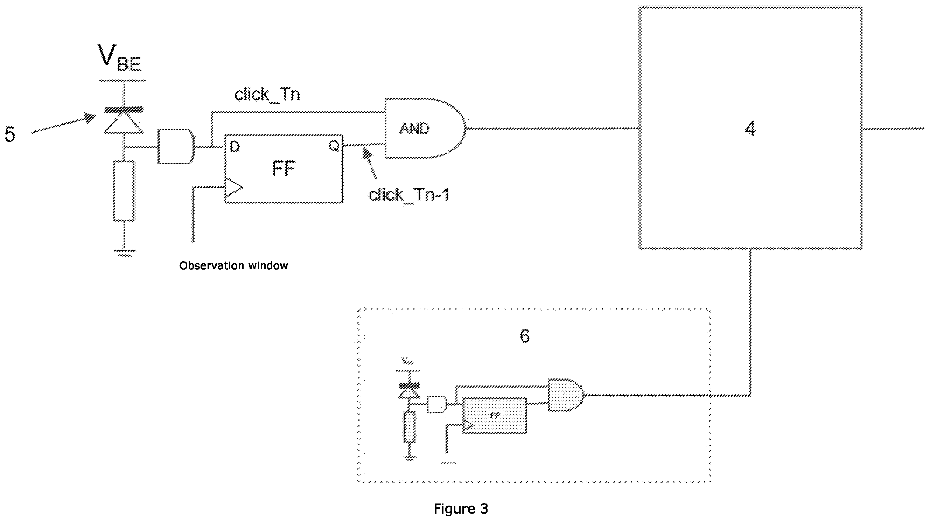

Figure 3 shows a possible circuit for an SPD detector element according to the invention, whereby an (optional) coincidence condition is also imposed after the persistence condition via a circuit (4) to this end. The persistence condition is hereby imposed that two consecutive observation windows must show a positive observation status.

A photon detector, SPD or SPAD, (5) is connected in series with a resistor across a voltage V_{BE}, relative to the ground. In case of a photon incidence on the detector, this leads to a breakdown in the detector, and a current across the resistor (or in other words, a change of the voltage at the point between the detector and the resistor). Said circuit with resistor is referred to as "passive quenching". It goes without saying that other "quenching" circuits such as "active quench" circuits are also applicable. Subsequently, a pulse detector is provided which converts the measured voltage in a discrete signal (whereby 1 indicates a positive observation status, or therefore the detection of a photon incidence during the observation window; and 0 a negative observation status, or therefore the non-detection thereof).

The signal that indicates the observation status of an observation window click_Tₙ₋₁ is subsequently in fact provided with a delay via a flipflop (FF) according to the period of the observation windows (by clocking the FF with the rising edge of the observation window), and subsequently combined via an AND-port with the 'new', current signal which indicates the observation status as belonging to observation window click_Tₙ. If both observation statuses are positive. Thus, the AND-port delivers a 1-confirmation signal at its output, which can then be used in the further processing of the signals, such as for example a combination with the signals from neighbouring detector elements (6).

It is understood that based on Figure 3 even more observation statuses can simply be included, by providing further flipflop components or memory elements, which via logical circuits then impose the desired persistence condition.

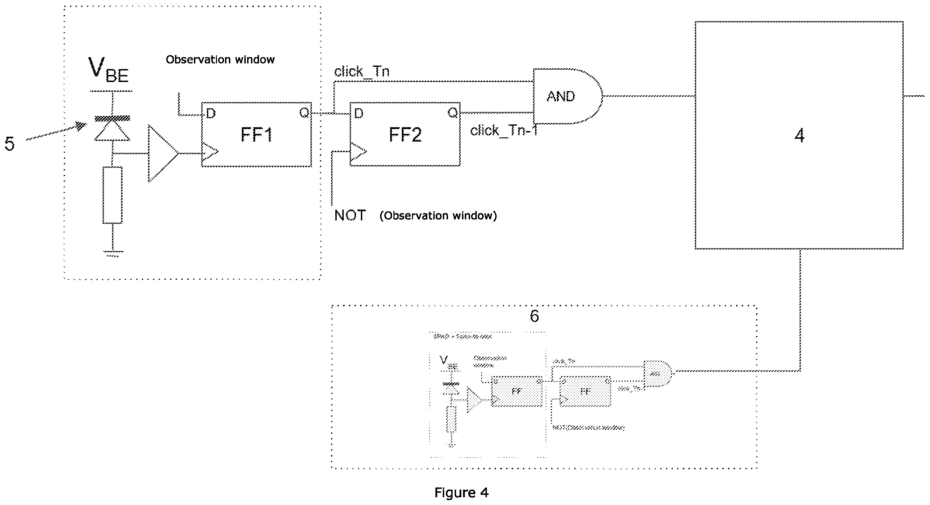

Figure 4 shows a further adaptation, where a first flipflop (FF1) uses the detection signal of the SPD (5) to clock the first flipflop (FF1), such that when this occurs during an observation window (and said signal therefore generates a 1), FF1 also clocks a 1. Without an observation window (signal = 0) a 0 is also clocked as input for the second flipflop (FF2), where the falling edge of the observation window (not - observation window) acts as clock trigger this time, such that when the observation status from the following observation window ("click_Tn") comes as data output Q from the first flipflop, the observation status of the previous observation window ("click_Tn-1") is in the second flipflop, which are then combined with the AND-port that follows.

By adding further flipflops which use the delay, further conditions can be imposed, such as three consecutive positive observation statuses.

This can again be followed by one or more circuits (4) which impose coincidence conditions.

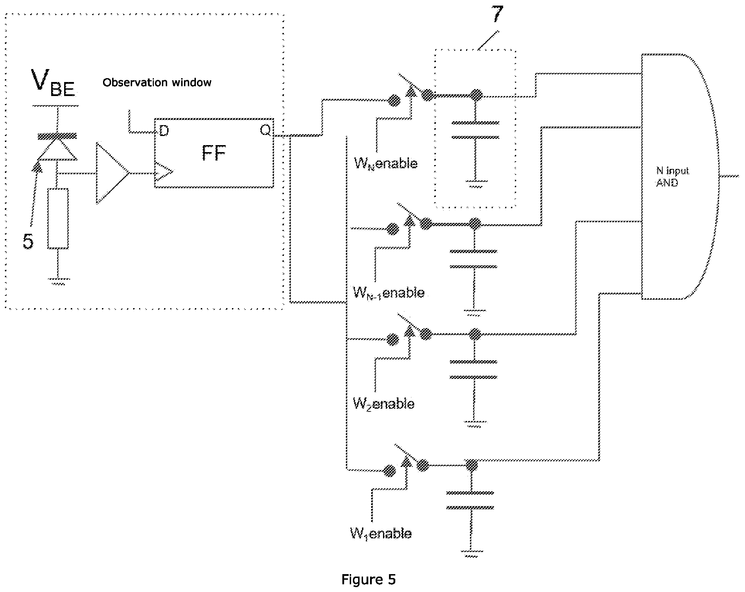

Figure 5 shows a circuit where the past N observation statuses are kept in N memory elements (7). The circuit for determining the observation status leads the signal of the SPD (5) to the clock of the flipflop (FF), whereby the signal of the observation window works as data input (D) for the flipflop (FF), such that data output (Q) 1 is generated when the SPD detects a photon incidence in an observation window and a 0 in the absence thereof.

The signal from the flipflop is saved in consecutive memory elements, whereby they are cyclically run through as storage. The memory elements provide the signal saved therein to a logical circuit which imposes the persistence conditions depending on their setting. The person skilled in the art can simply convert the conditions in a circuit using simple components, and they will not be discussed further here. For Figure 5, for the sake of convenience, an N input -AND port is provided, such that the persistence condition requires that in N of the past N observation windows a photon incidence must be detected to generate a confirmation signal (and then for example supplied further to a processing unit, which possibly imposes coincidence conditions).

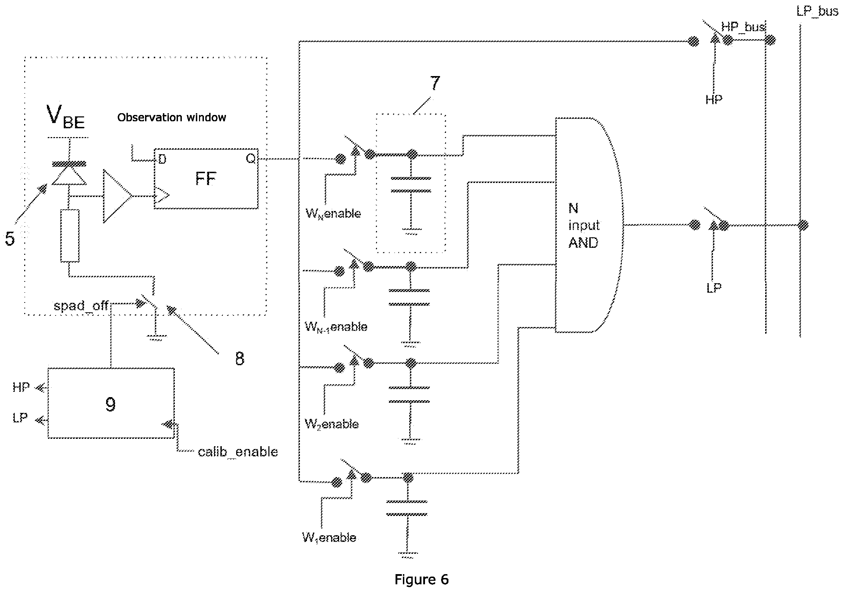

Figure 6 shows a circuit where the circuit of Figure 5 is supplemented with a calibration circuit (9) which operates according to the routines discussed in the description. Based on the result of a calibration routine and the calibration conditions, a High Priority (HP) or Low Priority (LP) is assigned to the SPD (5) in this case, the consequence being that in case of HP the observation status is not subjected to any further persistence condition, and immediately leads to a confirmation signal. With an LP classification, stricter persistence conditions are applied, in this case again the N positive observation statuses in the past N observation windows before a confirmation signal is generated. The SPD can also be switched off by the calibration routine if an issue is detected, (saturated SPD for example), via a switch (8).

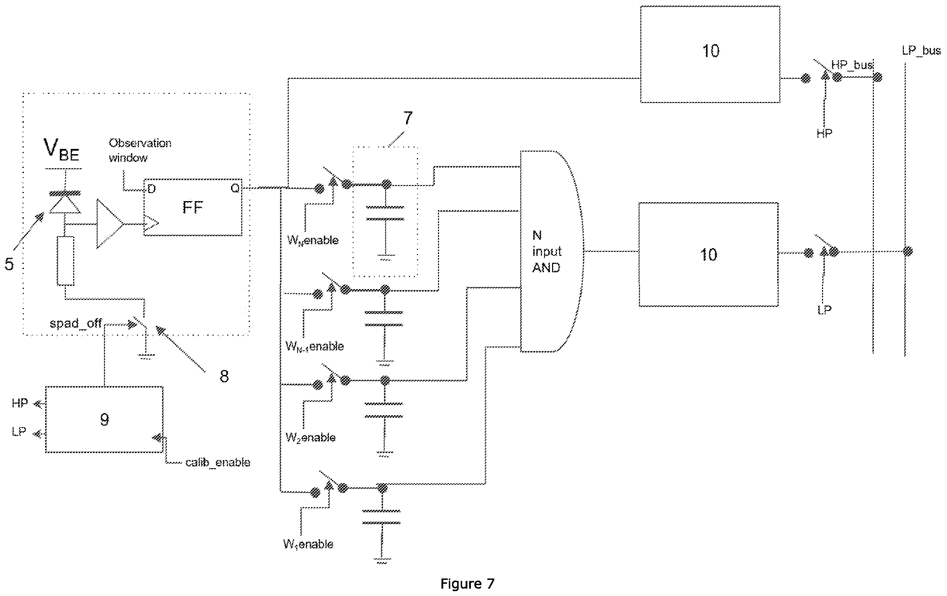

In Figure 7, a coincidence condition is locally imposed on the confirmation signals before they are forwarded to further processing units. For the exact development of coincidence conditions, PCT/IB2021/054688, BE2020/5975 and BE2021/5521, among others, are referred to. The confirmation signals from the persistence circuit of Figure 6 are hereby processed by a coincidence circuit (10) before being forwarded to a suitable bus.

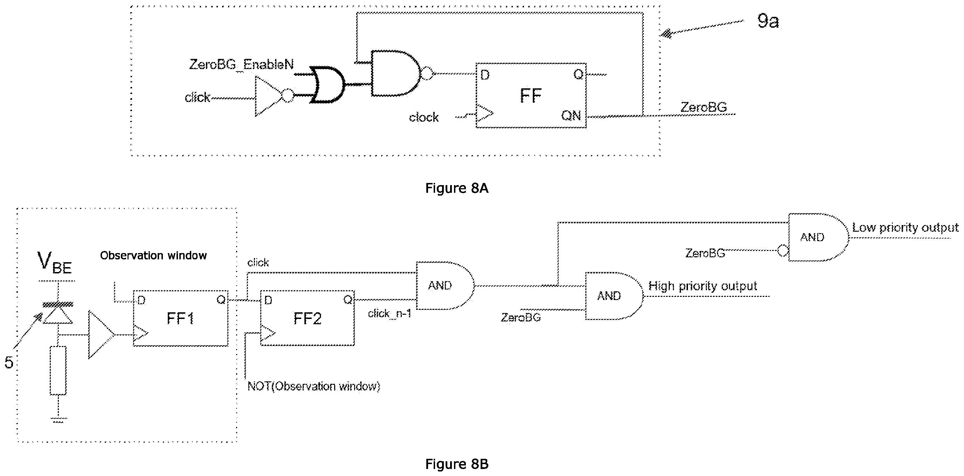

Figure 8A shows a possible application of a circuit to impose a first possible calibration condition on an SPD (5) via a calibration circuit (9a), i.e. the absence of photon incidences over the past N calibration windows. The incoming 'click' signal indicates the possible detection of a photon incidence (detection signal), which is subsequently sent via an inverter to an OR-port, together with a signal that indicates whether the calibration routine is running. Said combination only results in a 0 if there is both a photon incidence (1 as detection signal) and the calibration routine is running (and the calibration condition is therefore not met in said calibration window). The output of the OR-port is delivered to a NAND-port, together with the inverted Q-output of a flipflop (FF). The output of the NAND-port goes to the data input D of the flipflop, which is clocked based on the start of each of the calibration windows. As long as no photon incidence took place, the signal delivered to the data input remains on 0, and the inverted Q output (QN) generates 1, which is looped back to the data input via the NAND-port and the "new" signal of the next calibration window, which therefore generates 1 as long as there is no photon incidence (as the 'click' is then 0, and inverted if 1 is delivered to the OR port, and therefore delivers a 1 to the NAND-port).

As long as the calibration routine continues to run (and ZeroBG_EnableN = 1), the flipflop (FF) keeps repeating this loop. As soon as one photon incidence is detected, the flipflop generates a 0 as inverted output which via the inverted NAND-port always generates a 1, and thus again keeps looping an inverted output of 0.

The resulting signal ZeroBG is subsequently used to classify the signal from the persistence routine as meeting the calibration condition or not, and thus can be used as HP or LP output, via the ports in the circuit of Figure 8B.

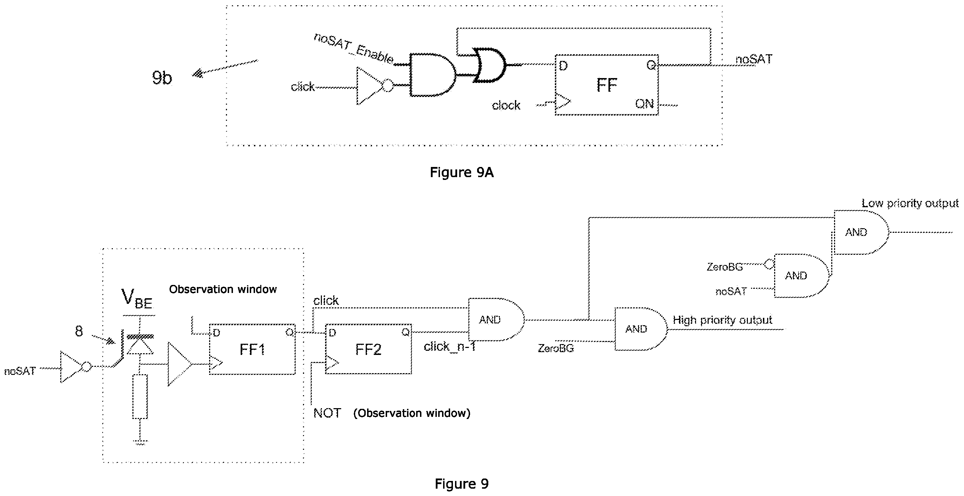

Figure 9A shows a possibility to, in addition to the calibration circuit of Figure 8A, provide yet another second calibration circuit (9b), which further expands the possible classifications for an SPD (5). Where the calibration circuit (9a) of Figure 8A tries to determine which SPDs are not (or less) sensitive to background radiation (or thermal noise or the like), the second calibration circuit is aimed at determining whether saturated SPDs are present, which in other words will always indicate a detection.

The signal of the SPD ("click") is delivered invertedly to an AND-port together with that of the calibration routine. If this calibration routine is running (noSAT_Enable = 1), and a photon incidence or photon event is detected ("click" = 1), this generates a 0 from the AND-port, and a 1 if there is no event.

The signal from the AND-port is input for an OR-port, together with the looped data output Q of the flipflop (FF). The result from the OR-port is then the data input for the flipflop, with as clock signal that of the calibration windows.

If there is no event (signal 1 to the OR-port), this automatically generates a 1 to the data input, and thereofore a 1 to the data output Q. Said data output Q of 1 then goes back to the OR-port (automatically 1 again) and thus to the data input, which is thus 1 again, which continues to loop like this. This means that if during said second calibration routine there is (at least one) a calibration window in which no event takes place, the calibration circuit will deliver a 1, which means that the SPD is not saturated.

If events occur in every calibration window (click = 1), the OR-port will always receive a 0 from the SPD (after the AND-port), which subsequently continues to loop unless preceded by a 1 signal to the data output Q of the flipflop (FF). In case of continuous events the output of said second calibration circuit will therefore generate a 0, which indicates that the SPD is saturated. In case of a noSAT of 0 (saturated) ZeroBG will therefore always have 0 as signal, as events will always be visible.

The resulting signal noSAT is subsequently used to classify the signal from the persistence routine as meeting the second calibration condition or not, and thus in the circuit of Figure 9B, together with the first calibration circuit of Figure 8A and the ensuing signal ZeroBG, to classify the SPDs and adjust the processing of the results.

Thus, the presented circuit with a noSAT of 0 (saturated SPD) - and therefore also a ZeroBG of 0 - will always lead to the rejection of the signal from the SPD, even if it meets the persistence condition.

On the other hand, in case of a non-saturated SPD (noSAT=1), ZeroBG determines whether the SPD is processed as high priority or low priority.

Finally, a noSAT of 0 (saturated SPD), will also switch off the SPD via an additional circuit (8).

It is assumed that the present invention is not restricted to the embodiments described above and that a number of modifications or changes can be added to the described examples within the scope of the appended claims.

## Claims

1. Method for high-speed imaging based on an array comprising a plurality of single photon detectors SPD (5), preferably single photon avalanche detectors SPAD (5), comprising the following steps:
a. capturing photons on the SPDs (5), whereby the SPDs (5) generate a detection signal C_ov and provide it to an evaluation circuit, whereby the detection signal describes a positive observation status when an observation takes place by the SPD (5) of an electromagnetic radiation to be detected, and describes a negative observation status in the absence of the observation by the SPD (5) of the electromagnetic radiation to be detected;
b. evaluing the detection signals of the SPD (5) by the evaluation circuit per SPD (5), whereby a persistence condition must be met by the detection signals per SPD to generate a confirmation signal for the SPD (5);
**characterised in that**
for at least one, and preferably every, SPD (5) the persistence condition requires a positive observation status for the same SPD (5) in at least M, preferably consecutive, observation windows (2), preferably with period T, over the past N observation windows (2), with M greater than 1 and at most equal to N.

2. Method for high-speed imaging according to the previous claim 1, comprising a step of illuminating a scene with one or more scanning light sources based on a predefined illumination pattern comprising temporally separated light pulses, whereby each of the observation windows (2) is temporally associated to one of the light pulses, and the detection signal shows the occurrence or non-occurrence of an observation by the SPD (5) as a result of the light pulse associated to the observation window (2).

3. Method for high-speed imaging according to the previous claim 2, in which the observation windows have a start time which substantially coincides with the start time of the associated light pulse, whereby substantially coinciding implies that the start time of the observation window (2) lies between 0 ns and at most 1.0 ns after the start time of the light pulse, preferably at most 0.5 ns, and more preferably at most 0.1 ns.

4. Method for high-speed imaging according to the previous claim 2 or 3, whereby the observation windows (2) have an end time which lies between 0.0 ns and 25.0 ns after the end time of the associated light pulse, preferably between 0.05 ns and 15.0 ns, more preferably between 0.1 ns and 10.0 ns, after the end time of the associated light pulse.

5. Method for high-speed imaging according to the previous claim 1, comprising a step of illuminating a scene with one or more scanning light sources, whereby the light sources illuminate the scene substantially continuously.

6. Method for high-speed imaging according to any one of the previous claims 1 to 5, in which M and/or N are adjustable, and preferably adjustable per SPD (5).

7. Method for high-speed imaging according to any one of the previous claims 1 to 6, whereby a confirmation signal for a first SPD that meets the persistence condition is generated if a coincidence condition is met, whereby the coincidence condition requires meeting the persistence condition by at least one other SPD for the observation window, whereby the at least one other SPD is adjacent to the first SPD that meets the persistence condition.

8. Method for high-speed imaging according to any one of the previous claims 1 to 6, whereby a confirmation signal for a first SPD is generated if a coincidence condition and the persistence condition are met, whereby the evaluation circuit is configured for imposing the persistence condition after imposing the coincidence condition and only for SPDs (5) which meet the coincidence condition, whereby the coincidence condition comprises the receipt by at least one other SPD (5) of a detection signal with a positive observation status within a certain time interval from the receipt of the detection signal with a positive observation status by the first SPD (5), whereby the at least one other SPD (5) is adjacent to the first SPD (5) on which the coincidence condition is imposed.

9. Method for high-speed imaging according to any one of the previous claims 7 or 8, whereby the SPDs (5) in the array are positioned in a substantially rectangular matrix, whereby an SPD (5) is adjacent to another SPD (5) with the SPD (5) having a matrix position i,j, with i being the row and j being the column in the matrix, and the other SPD (5) having a matrix position i,j±1 and optionally i±1,j or i±1,j±1.

10. Method according to the previous claims 1 to 9, whereby prior to imaging, a calibration routine is executed, the calibration routine comprising the following steps:
a. monitoring the detection signals of the SPD (5) by the evaluation circuit per SPD (5) over a calibration time period, in at least two, preferably at least three, calibration windows in the calibration time period, said calibration windows being temporally separated from each other, and whereby during the calibration time periods, the SPD (5) is not actively illuminated by the one or several light sources;
b. classifying the SPDs (5) based on the number of calibration windows in which an observation by the SPD (5) takes place.

11. Method according to the previous claim 10, in which the SPDs (5) are classified across at least two, preferably three classifications, whereby a persistence condition associated to the classification of the SPD (5) is imposed for generating a confirmation signal for the SPD (5).

12. Detector element (6) for detecting an electromagnetic radiation, comprising:
a. a single photon detector SPD (5), preferably a single photon avalanche detector SPAD (5), configured to generate a signal C_ov which describes a status of the occurrence or non-occurrence of an observation by the SPD (5) of the electromagnetic radiation to be detected for consecutive observation windows (2);
b. a memory element (7) that remembers the status of the SPD (5) at the end of at least N previous observation windows (2), N being a natural number equal to or greater than 1;
c. a logical circuit (4) configured to generate a confirmation signal if the signal of the SPD at the end of a current observation window (2) and from at least M of the N previous observation windows (2) indicates an observation by the SPD (5), M being a natural number equal to or greater than 1 and at most equal to N.

13. Sensor system for high-speed imaging, comprising
a. a matrix/array of detector elements (6) according to claim 12;
b. a circuit (4) for reading the detector elements (6) in the matrix/array.

14. Sensor system according to the previous claim 13, whereby the sensor system is configured to execute the method according to any one of the previous claims 1 to 11.

## Patentansprüche

1. Verfahren zur Hochgeschwindigkeits-Bildgebung auf der Grundlage eines Arrays mit einer Vielzahl von Einzelphotonen-Detektoren (Single Photon Detectors - SPD)(5), vorzugsweise Einzelphotonen-Avalanche-Detektoren (Single Photon Avalanche Detectors - SPAD) (5), das folgende Schritte umfasst:
a. Einfangen von Photonen auf den SPD (5), wobei die SPD (5) ein Detektionssignal C_ov erzeugen und einer Auswerteschaltung zur Verfügung stellen, wobei das Detektionssignal einen positiven Beobachtungszustand beschreibt, wenn eine Beobachtung einer zu detektierenden elektromagnetischen Strahlung durch den SPD (5) stattfindet, und einen negativen Beobachtungszustand beschreibt, wenn die Beobachtung der zu detektierenden elektromagnetischen Strahlung durch den SPD (5) ausbleibt;
b. Auswertung der Detektionssignale des SPD (5) durch die Auswerteschaltung jedes SPD (5), wobei eine Persistenzbedingung durch die Detektionssignale pro SPD erfüllt sein muss, um ein Bestätigungssignal für den SPD (5) zu erzeugen;
**dadurch gekennzeichnet, dass**
für mindestens einen, vorzugsweise für jeden SPD (5) die Persistenzbedingung einen positiven Beobachtungsstatus für denselben SPD (5) in mindestens M, vorzugsweise aufeinanderfolgenden, Beobachtungsfenstern (2) erfordert, vorzugsweise mit der Periode T, über die vergangenen N Beobachtungsfenster (2), wobei M größer als 1 und höchstens gleich N ist.

2. Verfahren zur Hochgeschwindigkeits-Bildgebung nach dem vorhergehenden Anspruch 1, das einen Schritt des Beleuchtens einer Szene mit einer oder mehreren Abtastlichtquellen auf der Grundlage eines vordefinierten Beleuchtungsmusters umfasst, das zeitlich getrennte Lichtimpulse umfasst, wobei jedes der Beobachtungsfenster (2) zeitlich einem der Lichtimpulse zugeordnet ist und das Erfassungssignal das Auftreten oder Nichtauftreten einer Beobachtung durch den SPD (5) als Ergebnis des dem Beobachtungsfenster (2) zugeordneten Lichtimpulses zeigt.

3. Verfahren zur Hochgeschwindigkeits-Bildgebung nach dem vorhergehenden Anspruch 2, bei dem die Beobachtungsfenster einen Startzeitpunkt haben, der im Wesentlichen mit dem Startzeitpunkt des zugehörigen Lichtimpulses übereinstimmt, wobei "im Wesentlichen übereinstimmen" bedeutet, dass der Startzeitpunkt des Beobachtungsfensters (2) zwischen 0 ns und höchstens 1,0 ns nach dem Startzeitpunkt des Lichtimpulses liegt, vorzugsweise höchstens 0,5 ns, und besonders bevorzugt höchstens 0,1 ns.

4. Verfahren zur Hochgeschwindigkeits-Bildgebung nach dem vorhergehenden Anspruch 2 oder 3, wobei die Beobachtungsfenster (2) eine Endzeit aufweisen, die zwischen 0,0 ns und 25,0 ns nach der Endzeit des zugehörigen Lichtimpulses liegt, vorzugsweise zwischen 0,05 ns und 15,0 ns, besonders bevorzugt zwischen 0,1 ns und 10,0 ns, nach der Endzeit des zugehörigen Lichtimpulses.

5. Verfahren zur Hochgeschwindigkeits-Bildgebung nach dem vorhergehenden Anspruch 1, das einen Schritt der Beleuchtung einer Szene mit einer oder mehreren Abtastlichtquellen umfasst, wobei die Lichtquellen die Szene im Wesentlichen kontinuierlich beleuchten.

6. Verfahren zur Hochgeschwindigkeits-Bildgebung nach einem der vorhergehenden Ansprüche 1 bis 5, bei dem M und/oder N einstellbar sind, vorzugsweise einstellbar pro SPD (5).

7. Verfahren zur Hochgeschwindigkeits-Bildgebung nach einem der vorhergehenden Ansprüche 1 bis 6, wobei ein Bestätigungssignal für einen ersten SPD, der die Persistenzbedingung erfüllt, erzeugt wird, wenn eine Koinzidenzbedingung erfüllt ist, wobei die Koinzidenzbedingung die Erfüllung der Persistenzbedingung durch mindestens einen anderen SPD für das Beobachtungsfenster erfordert, wobei mindestens ein anderer SPD dem ersten SPD, der die Persistenzbedingung erfüllt, benachbart ist.

8. Verfahren zur Hochgeschwindigkeits-Bildgebung nach einem der vorhergehenden Ansprüche 1 bis 6, wobei ein Bestätigungssignal für einen ersten SPD erzeugt wird, wenn eine Koinzidenzbedingung und die Persistenzbedingung erfüllt sind, wobei die Auswerteschaltung zum Auferlegen der Persistenzbedingung nach Auferlegen der Koinzidenzbedingung und nur für SPD (5), die die Koinzidenzbedingung erfüllen, konfiguriert ist, wobei die Koinzidenzbedingung den Empfang eines Detektionssignals mit einem positiven Beobachtungsstatus durch mindestens einen anderen SPD (5) innerhalb eines bestimmten Zeitintervalls ab dem Empfang des Detektionssignals mit einem positiven Beobachtungsstatus durch den ersten SPD (5) umfasst, wobei mindestens ein anderer SPD (5) dem ersten SPD (5) benachbart ist, für den die Koinzidenzbedingung auferlegt wird.

9. Verfahren zur Hochgeschwindigkeits-Bildgebung nach einem der vorhergehenden Ansprüche 7 oder 8, wobei die SPD (5) in dem Array in einer im Wesentlichen rechteckigen Matrix positioniert sind, wobei ein SPD (5) einem anderen SPD (5) benachbart ist, wobei der SPD (5) eine Matrixposition i,j hat, wobei i die Zeile und j die Spalte in der Matrix ist, und der andere SPD (5) eine Matrixposition i,j±l und optional i±1,j oder i±1, j±1 hat.

10. Verfahren nach einem der vorhergehenden Ansprüche 1 bis 9, wobei vor der Bildgebung eine Kalibrierungsroutine ausgeführt wird, wobei die Kalibrierungsroutine die folgenden Schritte umfasst:
a. Überwachung der Detektionssignale des SPD (5) durch die Auswerteschaltung pro SPD (5) über einen Kalibrierungszeitraum, in mindestens zwei, vorzugsweise mindestens drei Kalibrierungsfenstern im Kalibrierungszeitraum, wobei die Kalibrierungsfenster zeitlich voneinander getrennt sind, und wobei während der Kalibrierungszeiträume der SPD (5) nicht aktiv von der einen oder den mehreren Lichtquellen beleuchtet wird;
b. Klassifizierung der SPD (5) auf der Grundlage der Anzahl der Kalibrierungsfenster, in denen eine Beobachtung durch den SPD (5) stattfindet.

11. Verfahren nach dem vorhergehenden Anspruch 10, bei dem die SPD (5) über mindestens zwei, vorzugsweise drei Klassifizierungen klassifiziert werden, wobei eine der Klassifizierung des SPD (5) zugeordnete Persistenzbedingung zur Erzeugung eines Bestätigungssignals für den SPD (5) auferlegt wird.

12. Detektorelement (6) zur Erfassung einer elektromagnetischen Strahlung, umfassend:
a. einen Einzelphotonen-Detektor SPD (5), vorzugsweise einen Einzelphotonen-Avalanche-Detektor SPAD (5), der so konfiguriert ist, dass er ein Signal C_ov erzeugt, das einen Status des Auftretens oder Nichtauftretens einer Beobachtung der zu erfassenden elektromagnetischen Strahlung durch den SPD (5) für aufeinanderfolgende Beobachtungsfenster (2) beschreibt;
b. ein Speicherelement (7), das den Zustand des SPD (5) am Ende von mindestens N vorhergehenden Beobachtungsfenstern (2) speichert, wobei N eine natürliche Zahl gleich oder größer als 1 ist;
c. eine logische Schaltung (4), die so konfiguriert ist, dass sie ein Bestätigungssignal erzeugt, wenn das Signal des SPD am Ende eines aktuellen Beobachtungsfensters (2) und von mindestens M der N vorhergehenden Beobachtungsfenster (2) eine Beobachtung durch den SPD (5) anzeigt, wobei M eine natürliche Zahl gleich oder größer als 1 und höchstens gleich N ist.

13. Sensorsystem für Hochgeschwindigkeits-Bildgebung, bestehend aus
a. einer Matrix/einem Array von Detektorelementen (6) nach Anspruch 12;
b. einer Schaltung (4) zum Auslesen der Detektorelemente (6) in der Matrix/dem Array.

14. Sensorsystem nach dem vorhergehenden Anspruch 13, wobei das Sensorsystem zur Durchführung des Verfahrens nach einem der vorhergehenden Ansprüche 1 bis 11 konfiguriert ist.

## Revendications

1. Procédé d'imagerie à grande vitesse basé sur un réseau comprenant une pluralité de détecteurs monophotoniques DMP (5), de préférence des détecteurs à avalanche monophotonique DAMP (5), comprenant les étapes suivantes :
a. capture de photons sur les DMP (5), dans laquelle les DMP (5) génèrent un signal de détection C_ov et le transmettent à un circuit d'évaluation, dans lequel le signal de détection décrit un état d'observation positif lorsqu'une observation d'un rayonnement électromagnétique à détecter est effectuée par le DMP (5) et décrit un état d'observation négatif en l'absence d'observation, par le DMP (5), du rayonnement électromagnétique à détecter;
b. évaluation des signaux de détection du DMP (5) par le circuit d'évaluation pour chaque DMP (5), dans laquelle une condition de persistance doit être remplie par les signaux de détection pour chaque DMP pour générer un signal de confirmation pour le DMP (5) ; **caractérisé en ce que** pour au moins un, et de préférence chaque, DMP (5), la condition de persistance nécessite un état d'observation positif pour le même DMP (5) dans au moins M fenêtres d'observation (2), de préférence consécutives, de préférence avec une période T, sur les dernières N fenêtres d'observation (2), avec M supérieur à 1 et au plus égal à N.

2. Procédé d'imagerie à grande vitesse selon la revendication 1 précédente, comprenant une étape consistant à éclairer une scène avec une ou plusieurs sources lumineuses de balayage sur la base d'un modèle d'éclairage prédéfini comprenant des impulsions lumineuses séparées dans le temps, dans lequel chacune des fenêtres d'observation (2) est associée temporellement à l'une des impulsions lumineuses, et le signal de détection indique l'occurrence ou la non-occurrence d'une observation par le DMP (5) résultant de l'impulsion lumineuse associée à la fenêtre d'observation (2).

3. Procédé d'imagerie à grande vitesse selon la revendication 2 précédente, dans lequel les fenêtres d'observation ont une heure de début qui coïncide sensiblement avec l'heure de début de l'impulsion lumineuse associée, ce qui implique que l'heure de début de la fenêtre d'observation (2) se situe entre 0 ns et au plus 1,0 ns après l'heure de début de l'impulsion lumineuse, de préférence au plus 0,5 ns, et plus de préférence au plus 0,1 ns.

4. Procédé d'imagerie à grande vitesse selon la revendication 2 ou 3, dans lequel les fenêtres d'observation (2) ont une heure de fin qui se situe entre 0,0 ns et 25,0 ns après l'heure de fin de l'impulsion lumineuse associée, de préférence entre 0,05 ns et 15,0 ns, plus de préférence entre 0,1 ns et 10,0 ns, après l'heure de fin de l'impulsion lumineuse associée.

5. Procédé d'imagerie à grande vitesse selon la revendication 1 précédente, comprenant une étape consistant à éclairer une scène avec une ou plusieurs sources lumineuses de balayage, dans lequel, les sources lumineuses éclairent la scène de façon sensiblement continue.

6. Procédé d'imagerie à grande vitesse selon l'une quelconque des revendications précédentes 1 à 5, dans lequel M et/ou N sont réglables, et de préférence réglables pour chaque DMP (5).

7. Procédé d'imagerie à grande vitesse selon l'une quelconque des revendications précédentes 1 à 6, dans lequel un signal de confirmation est généré pour un premier DMP qui remplit la condition de persistance si une condition de coïncidence est remplie, la condition de coïncidence exigeant que la condition de persistance soit remplie par au moins un autre DMP pour la fenêtre d'observation, dans lequel le au moins un autre DMP est adjacent au premier DMP qui remplit la condition de persistance.

8. Procédé d'imagerie à grande vitesse selon l'une quelconque des revendications précédentes 1 à 6, où un signal de confirmation est généré pour un premier DMP si une condition de coïncidence et la condition de persistance sont remplies, le circuit d'évaluation étant conçu pour imposer la condition de persistance après l'imposition de la condition de coïncidence et uniquement pour les DMP (5) qui remplissent la condition de coïncidence, la condition de coïncidence comprenant au moins la réception par au moins un autre DMP (5) d'un signal de détection avec un état d'observation positif dans un certain intervalle de temps à compter de la réception du signal de détection avec un état d'observation positif par le premier DMP (5), le au moins un autre DMP (5) étant adjacent au premier DMP (5) auquel la condition de coïncidence est imposée.

9. Procédé d'imagerie à grande vitesse selon l'une quelconque des revendications précédentes 7 ou 8, dans lequel les DMP (5) dans le réseau sont positionnés dans une matrice sensiblement rectangulaire, dans lequel un DMP (5) est adjacent à un autre DMP (5), le DMP (5) ayant une position matricielle i,j, avec i étant la ligne et j étant la colonne dans la matrice, et l'autre DMP (5) ayant une position matricielle i,j±1 et éventuellement i±1,j ou i±1 ,j±1.

10. Procédé selon les revendications précédentes 1 à 9, dans lequel avant l'imagerie, une routine d'étalonnage est exécutée, laquelle comprend les étapes suivantes :
a. a. surveillance des signaux de détection du DMP (5) par le circuit d'évaluation pour chaque DMP (5) sur une période d'étalonnage, dans au moins deux, de préférence au moins trois, fenêtres d'étalonnage pendant la période d'étalonnage, lesdites fenêtres d'étalonnage étant temporellement séparées les unes des autres, et dans lequel, pendant les périodes d'étalonnage, le DMP (5) n'est pas éclairé activement par une ou plusieurs sources lumineuses ;
b. b. classement des DMP (5) en fonction du nombre de fenêtres d'étalonnage dans lesquelles une observation par le DMP (5) a lieu.

11. Procédé selon la revendication 10 précédente, dans lequel les DMP (5) sont classifiés selon au moins deux, de préférence trois classifications, dans lequel une condition de persistance associée à la classification du DMP (5) est imposée pour générer un signal de confirmation pour le DMP (5).

12. Élément de détection (6) pour détecter un rayonnement électromagnétique, comprenant :
a. un détecteur monophotonique DMP (5), de préférence un détecteur à avalanche monophotonique DAMP (5), configuré pour générer un signal C_ov qui décrit l'état d'occurrence ou de non-occurrence d'une observation du rayonnement électromagnétique à détecter par le DMP (5) pour des fenêtres d'observation consécutives (2) ;
b. un élément de mémoire (7) qui mémorise l'état du DMP (5) à la fin d'au moins N fenêtres d'observation précédentes (2), N étant un nombre entier naturel égal ou supérieur à 1 ;
c. un circuit logique (4), configuré pour générer un signal de confirmation si le signal du DMP à la fin d'une fenêtre d'observation courante (2) et à partir d'au moins M des N fenêtres d'observation précédentes (2), indique une observation par le DMP (5), M étant un nombre entier naturel égal ou supérieur à 1 et au plus égal à N.

13. Système de capteurs pour imagerie à grande vitesse, comprenant
a. une matrice/un réseau d'éléments de détection (6) selon la revendication 12 ;
b. un circuit (4) pour la lecture des éléments de détection (6) de la matrice/du réseau.

14. Système de capteurs selon la revendication 13 précédente, dans lequel le système de capteurs est configuré pour exécuter le procédé selon l'une quelconque des revendications 1 à 11 précédentes.
